(19) Europäisches Patentamt
European Patent Office
Office européen des brevets

(11) EP 3 101 476 A2

(12) EUROPEAN PATENT APPLICATION

(43) Date of publication:
07.12.2016 Bulletin 2016/49

(51) Int Cl.:
*G03F 7/00* (2006.01)

(21) Application number: 16001153.2

(22) Date of filing: 20.05.2016

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 02.06.2015 JP 2015112400

(71) Applicant: Canon Kabushiki Kaisha
Tokyo (JP)

(72) Inventors:
• Baba, Norikazu
Tokyo (JP)
• Fukagawa, Youzou
Tokyo (JP)

(74) Representative: WESER & Kollegen
Radeckestraße 43
81245 München (DE)

(54) IMPRINT APPARATUS, IMPRINT METHOD, AND ARTICLE MANUFACTURING METHOD

(57) An imprint apparatus for forming a pattern of an imprint material on a substrate using a mold, includes a driving unit configured to adjust a distance and a relative tilt between the mold and the substrate, an image capturing unit configured to capture a plurality of times an interference fringe formed by illuminating the substrate via the mold in a process of enlarging a contact area between the mold and the imprint material by reducing the distance between the mold and the substrate by the driving unit, and a control unit configured to control the driving unit so as to correct the relative tilt between the mold and the substrate a plurality of times in the process based on images captured by the image capturing unit a plurality of times.

FIG. 1

**Description**

BACKGROUND OF THE INVENTION

Field of the Invention

The present invention relates to an imprint apparatus, an imprint method, and an article manufacturing method.

Description of the Related Art

There is an imprint apparatus that forms a pattern on an imprint material on a substrate using a mold. Japanese Patent Laid-Open No. 2015-56589 describes curving a mold, bringing it into contact with an imprint material on a substrate, and gradually making the curve of the mold small, thereby enlarging the contact area between the mold and the imprint material. Japanese Patent Laid-Open No. 2015-56589 also describes observing an interference fringe formed around the contact area between the mold and the imprint material and adjusting the tilt of the mold or substrate based on the direction and amount of displacement of the interference fringe center from the shot region center.
The relative tilt between the mold and the substrate may change in accordance with a change in the distance between the mold and the substrate. Hence, in the process of enlarging the contact area between the mold and the imprint material by reducing the distance between the mold and the substrate, even if the relative tilt between the mold and the substrate is corrected at a certain point of time, the relative tilt may become large after that. If the imprint material is cured in a state with the large relative tilt, pattern formation to the imprint material on the substrate may fail.

SUMMARY OF THE INVENTION

The present invention provides a technique advantageous in reducing pattern formation failures.
The present invention in its first aspect provides an imprint apparatus as specified in claims 1 to 8.
The present invention in its second aspect provides an imprint method as specified in claim 9.
The present invention in its third aspect provides an article manufacturing method as specified in claim 10.
Further features of the present invention will become apparent from the following description of exemplary embodiments with reference to the attached drawings.

BRIEF DESCRIPTION OF THE DRAWINGS

Fig. 1 is a view schematically showing the arrangement of an imprint apparatus according to an embodiment of the present invention;
Fig. 2 is a flowchart showing the operation of the imprint apparatus shown in Fig. 1;
Figs. 3A and 3B are views exemplarily showing an interference fringe formed by a substrate and a curved mold;
Figs. 4A to 4F are views schematically showing enlargement of the contact area between a mold and an imprint material and a change in an interference fringe;
Fig. 5 is a view showing the center coordinates of an interference fringe and coordinates with respect to the center coordinates as the origin;
Figs. 6A to 6D are views exemplarily showing decentering of the interference fringe caused by enlargement of the contact area between the mold and the imprint material;
Figs. 7A and 7B are views showing light intensity distributions on the X- and Y-axes shown in Fig. 6D;
Figs. 8A and 8B are views exemplarily showing the relationship between decentering amounts Ax and Ay and tilts $\theta x$ and $\theta y$;
Figs. 9A and 9B are views visually showing the definition of the inner product of light intensity distributions; and
Fig. 10 is a view exemplarily showing a relative tilt $\theta$ and a peak value $S_p$ of the inner product in a contact-area enlarging process.

DESCRIPTION OF THE EMBODIMENTS

An exemplary embodiment of the present invention will now be described with reference to the accompanying drawings.

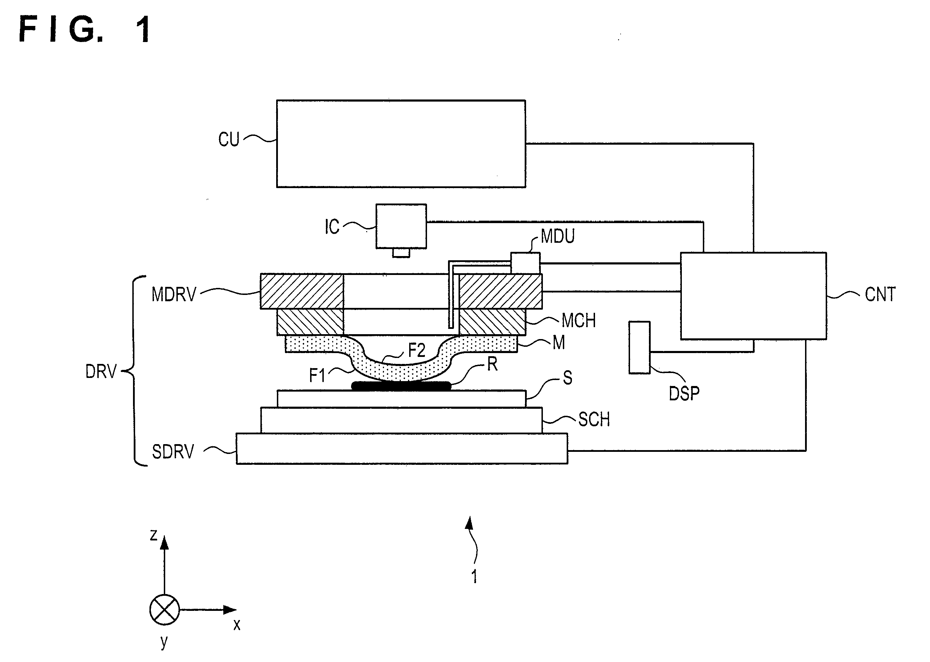

Fig. 1 schematically shows the arrangement of an imprint apparatus 1 according to an embodiment of the present invention. The imprint apparatus 1 is configured to form a pattern on an imprint material R on a substrate S using a mold M. That is, the imprint apparatus 1 is configured to form a pattern corresponding to the pattern of the mold M on the substrate S. The imprint apparatus 1 includes a driving unit DRV, a curing unit CU, a dispensing unit DSP, an image capturing unit IC, and a control unit CNT.

The driving unit DRV is configured to adjust the relative position and the relative tilt between the mold M and the substrate S. The driving unit DRV can include, for example, a mold holding unit MCH that holds the mold M, a mold driving unit MDRV that drives the mold holding unit MCH, a substrate holding unit SCH that holds the substrate S, and a substrate driving unit SDRV that drives the substrate holding unit SCH. The relative position and the relative tilt between the mold M and the substrate S can be adjusted or controlled by driving of the mold holding unit MCH by the mold driving unit MDRV and driving of the substrate holding unit SCH by the substrate driving unit SDRV. The mold driving unit MDRV can drive the mold holding unit MCH, for example, concerning all or some of the X-axis direction, the Y-axis direction, the Z-axis direction, rotation about the X-axis, rotation about the Y-axis, and rotation about the Z-axis. The substrate driving unit SDRV can drive the substrate holding unit SCH, for example, concerning all or some of the X-axis direction, the Y-axis direction, the Z-axis direction, rotation about the X-axis, rotation about the Y-axis, and rotation about the Z-axis. The Z-axis is a direction that defines the distance between the mold M and the substrate S. The X- and Y-axes are directions perpendicular to the Z-axis. The X-, Y-, and Z-axes define an XYZ coordinate system.

The driving unit DRV includes a mold deforming unit MDU that deforms the mold M held by the mold holding unit MCH. The mold M includes a first surface F1 on which a pattern (not shown) is formed, and a second surface F2 on the opposite side of the first surface F1. The mold deforming unit MDU can deform the mold M by, for example, controlling the pressure in the space on the side of the second surface F2. For example, when the pressure in the space on the side of the second surface F2 is made higher than that in the space on the side of the first surface F1, the mold M can be curved so as to project toward the substrate S or the imprint material R.

The dispensing unit DSP (resin supply unit) dispenses the imprint material R (for example, a resin) to the substrate S. The curing unit CU cures the imprint material R in a state in which the pattern of the mold M is in contact with the imprint material R on the substrate S. In one example, the imprint material R is a photocuring resin. The curing unit CU irradiates the imprint material R with light, thereby curing the imprint material R. In another example, the imprint material R is a thermosetting resin. The curing unit CU applies heat to the imprint material R, thereby curing the imprint material R.

The image capturing unit IC captures an interference fringe formed by illuminating the substrate S via the mold M. In the process (contact-area enlarging process) of enlarging the contact area between the mold M and the imprint material R by reducing the distance between the mold M and the substrate S by the driving unit DRV, the image capturing unit IC can be controlled to capture the interference fringe a plurality of times.

The control unit CNT controls the driving unit DRV, the image capturing unit IC, the curing unit CU, and the dispensing unit DSP. For example, the control unit CNT can control the driving unit DRV so as to correct the relative tilt between the mold M and the substrate S a plurality of times in the contact-area enlarging process based on images captured a plurality of times by the image capturing unit IC.

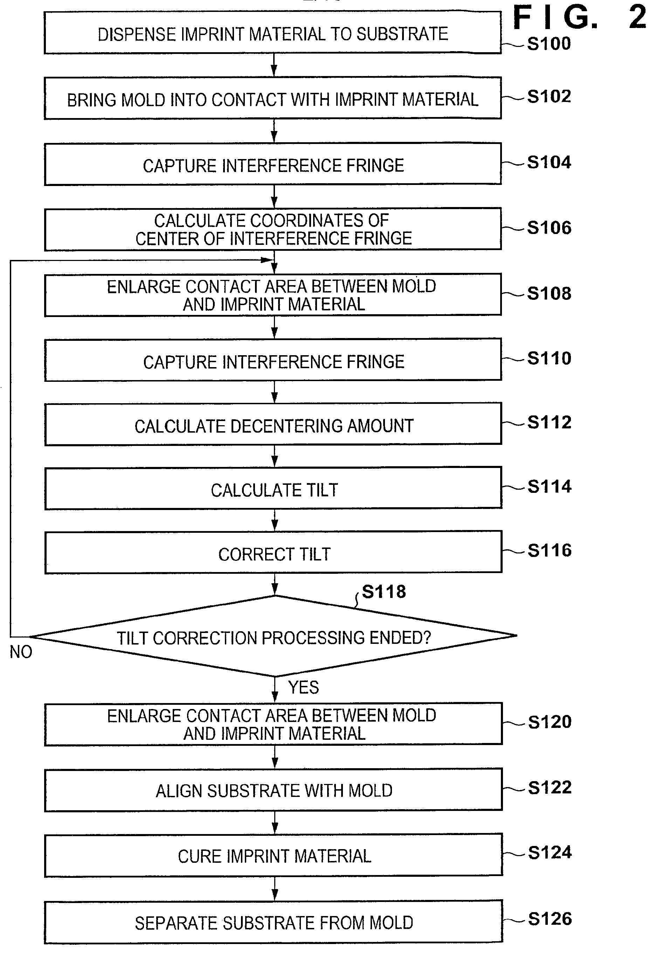

The operation of the imprint apparatus 1 will exemplarily be described with reference to Fig. 2. This operation can be controlled by the control unit CNT. The control unit CNT can be constructed by, for example, a CPU including a program. The control unit CNT may be constructed by a PLD (Programmable Logic Device) or an ASIC (Application-Specific Integrated Circuit). Alternatively, the control unit CNT may be constructed by a combination of at least two of a CPU including a program, a PLD, and an ASIC.

In step S100, the control unit CNT controls the dispensing unit DSP and the driving unit DRV such that the imprint material R is dispensed (supplied) to the substrate S. For example, when the substrate S is driven by the substrate driving unit SDRV to make a shot region as an imprint target on the substrate S enter a dispensing operation region of the dispensing unit DSP, and the dispensing unit DSP discharges the imprint material R, the imprint material R can be dispensed to the shot region.

In step S102, the control unit CNT controls the driving unit DRV so as to bring the pattern of the mold M into contact with the imprint material R on the substrate S. At this time, the mold deforming unit MDU, for example, makes the pressure in the space on the side of the second surface F2 higher than that in the space on the side of the first surface F1, thereby curving the mold M such that it projects toward the substrate S or the imprint material R.

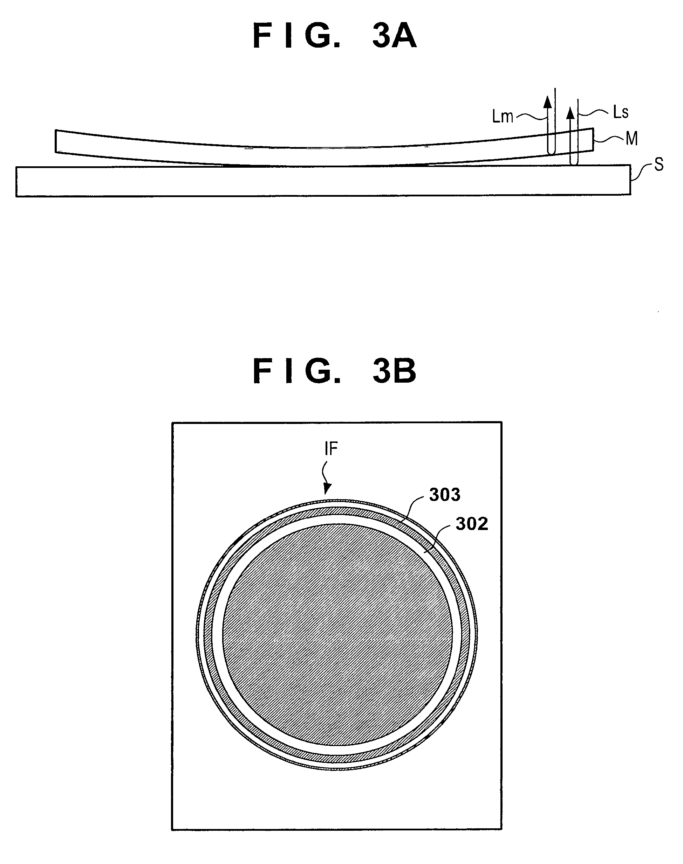

In step S104, the control unit CNT controls the image capturing unit IC so as to capture an image (to be referred to as a first image hereinafter) of an interference fringe formed by illuminating the substrate S via the mold M. As schematically shown in Figs. 3A and 3B, when the substrate S is illuminated via the mold M, an interference fringe IF can be formed by the optical path length difference between light Lm reflected by the mold M and light Ls reflected by the substrate S. The interference fringe IF is, for example, a Newton ring including a bright ring 302 and a dark ring 303. The bright ring 302 appears at a position where the optical path length difference is an integer multiple of the wavelength of the light, and the dark ring 303 appears at a position where the optical path length difference is a half-integer multiple of the wavelength of the light.

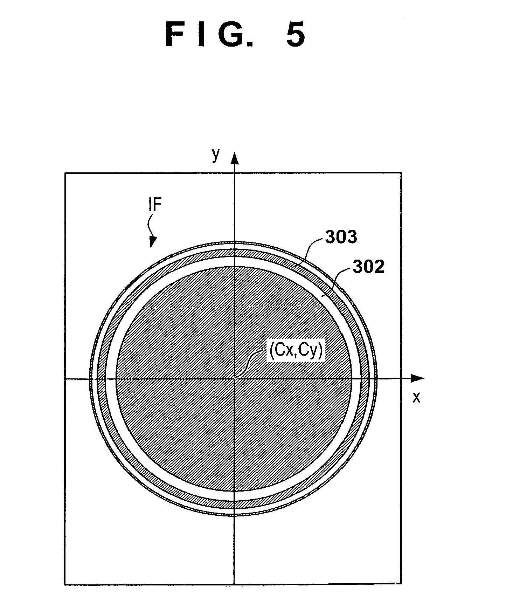

In step S106, the control unit CNT calculates center coordinates (Cx, Cy) of the interference fringe IF in the first image captured by the image capturing unit IC. The center coordinates (Cx, Cy) of the interference fringe IF can be, for example, the center coordinates of one of a plurality of rings including the bright ring 302 and the dark ring 303 or center coordinates decided from the center coordinates of the plurality of rings by the least square method or the like. Fig. 5 shows the center coordinates (Cx, Cy) of the interference fringe IF and X- and Y-axes with respect to the center coordinates (Cx, Cy) as the origin.

In step S108, the control unit CNT controls the mold deforming unit MDU so as to make the curve amount of the mold M small, thereby enlarging the contact area between the imprint material R and the pattern of the mold M. Steps S108 to S120 correspond to the contact-area enlarging process in which the driving unit DRV reduces the distance between the mold M and the substrate S, thereby enlarging the contact area between the mold M and the imprint material R. In the contact-area enlarging process, the driving unit DRV may maintain a predetermined distance between the mold M and the substrate S or change the distance so that it approaches a target distance. In the contact-area enlarging process, the control unit CNT controls the image capturing unit IC so as to capture the interference fringe IF a plurality of times, and controls the driving unit DRV so as to correct the relative tilt between the mold M and the substrate S based on the images captured the plurality of times.

In the contact-area enlarging process, the interference fringe IF changes along with the enlargement of the contact area between the imprint material R and the pattern of the mold M. In step S110, the control unit CNT controls the image capturing unit IC so as to capture an image (to be referred to as a second image hereinafter) of the interference fringe IF formed by illuminating the substrate S via the mold M. The second image is an image captured after the first image.

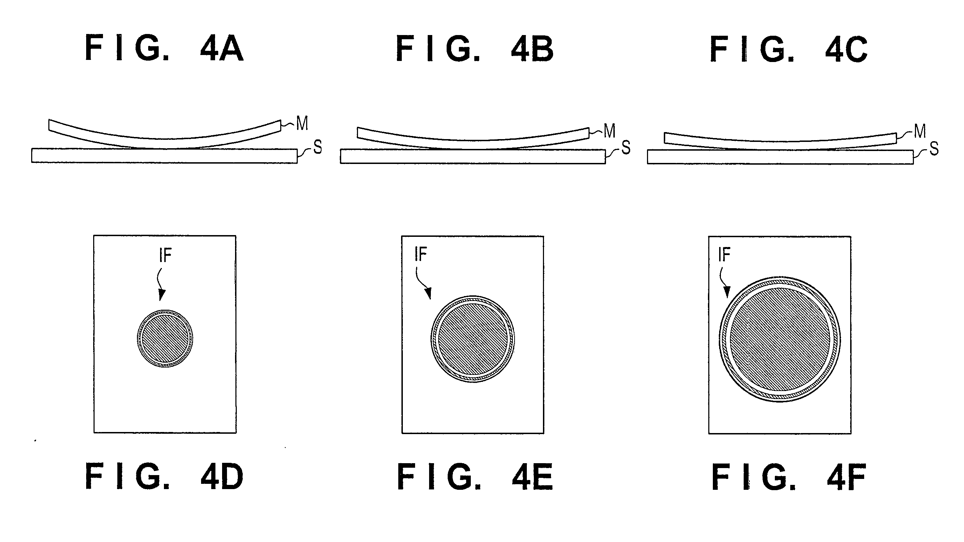

Figs. 4A to 4F schematically show enlargement of the contact area between the mold M and the imprint material R and a change in the interference fringe IF. When the contact area between the imprint material R and the pattern of the mold M is enlarged, as shown in Fig. 4A → Fig. 4B → Fig. 4C, the interference fringe IF accordingly changes, as shown in Fig. 4D → Fig. 4E → Fig. 4F.

In steps S112 to S116, the control unit CNT controls the driving unit DRV so as to correct the relative tilt between the mold M and the substrate S based on the decentering amount of the center of the interference fringe in the second image from the center of the interference fringe in the first image. That is, the control unit CNT controls the driving unit DRV so as to reduce the decentering amount of the center of the interference fringe in the second image from the center of the interference fringe in the first image. This means that the driving unit DRV is controlled such that the relative tilt between the mold M and the substrate S upon capturing the first image is maintained in the contact-area enlarging process.

The processes of steps S112 to S116 will be described below using a more detailed example. In step S112, as the decentering amounts of the center coordinates of the interference fringe in the second image from the center coordinates (Cx, Cy) of the interference fringe IF in the first image, the control unit CNT calculates decentering amounts Ax and Ay to be defined below.

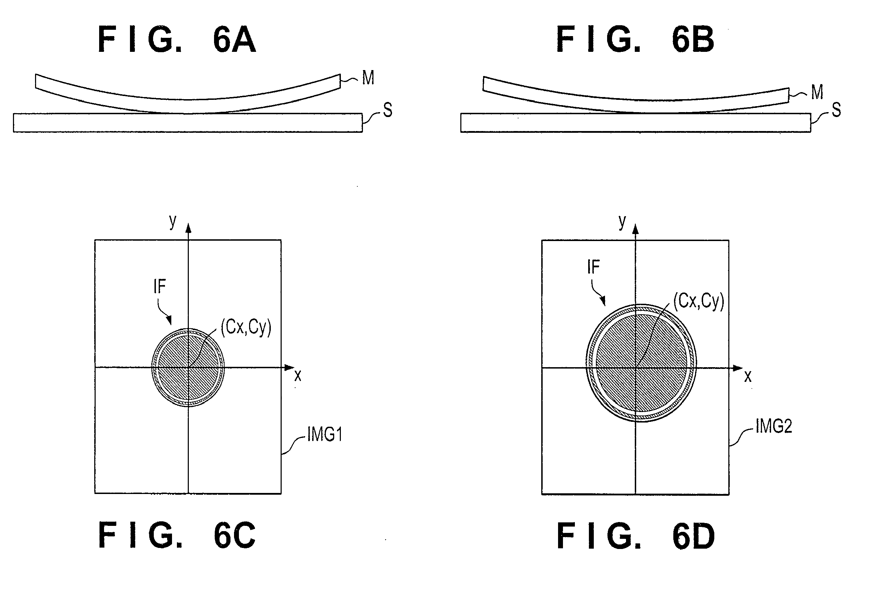

Fig. 6A schematically shows the curve of the mold M when capturing a first image IMG1 in step S104, and Fig. 6B schematically shows the curve of the mold M when capturing a second image IMG2 in step S110. Fig. 6C schematically shows the first image IMG1, and Fig. 6D schematically shows the second image IMG2. The decentering amounts Ax and Ay can be calculating by, for example, defining x- and y-coordinates with respect to the center coordinates (Cx, Cy) of the interference fringe in the first image IMG1 as the origin and performing calculation based on the x- and y-coordinate values of one ring of the interference fringe in the second image IMG2 under the x- and y-coordinates.

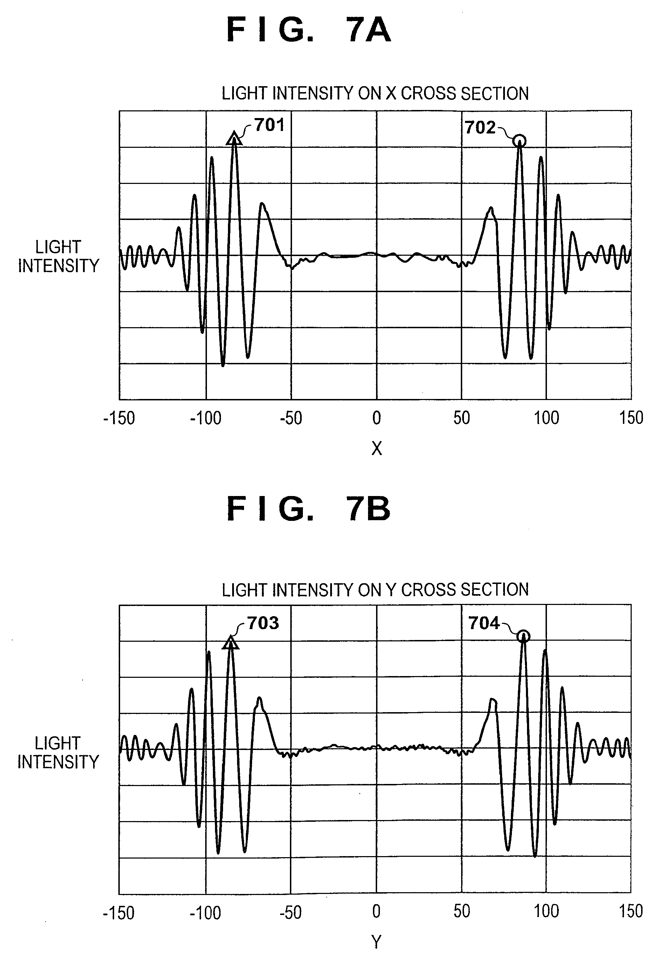

Fig. 7A shows a light intensity distribution on the X-axis shown in Fig. 6D. Referring to Fig. 7A, let Lx and Rx be the position of a left-side portion 701 of a given ring and the position of a right-side portion 702, respectively. Let Δx be the deviation amount, Mx be the average position, and Ax be the decentering amount. They can be defined as

$$\Delta x = Rx + Lx \qquad\qquad ...(1)$$

$$Mx = (Rx - Lx)/2 \qquad\qquad ...(2)$$

$$Ax = \Delta x/Mx \qquad\qquad ...(3)$$

Fig. 7B shows a light intensity distribution on the Y-axis shown in Fig. 6D. Referring to Fig. 7B, let Dy and Uy be the position of a lower-side portion 703 of a given ring and the position of an upper portion 704, respectively. Let Δy be the deviation amount, My be the average position, and Ay be the decentering amount. They can be defined as

$$\Delta y = Uy + Dy \qquad\qquad ...(4)$$

$$My = (Uy - Dy)/2 \qquad \ldots (5)$$

$$Ay = \Delta y/My \qquad \ldots (6)$$

That is, the control unit CNT can calculate the decentering amounts Ax and Ay in accordance with equations (3) and (6).

In step S114, the control unit CNT calculates relative tilts $\theta x$ and $\theta y$ between the mold M and the substrate S based on the decentering amounts Ax and Ay, where $\theta x$ is the tilt of an X-axis component, and $\theta y$ is the tilt of a Y-axis component.

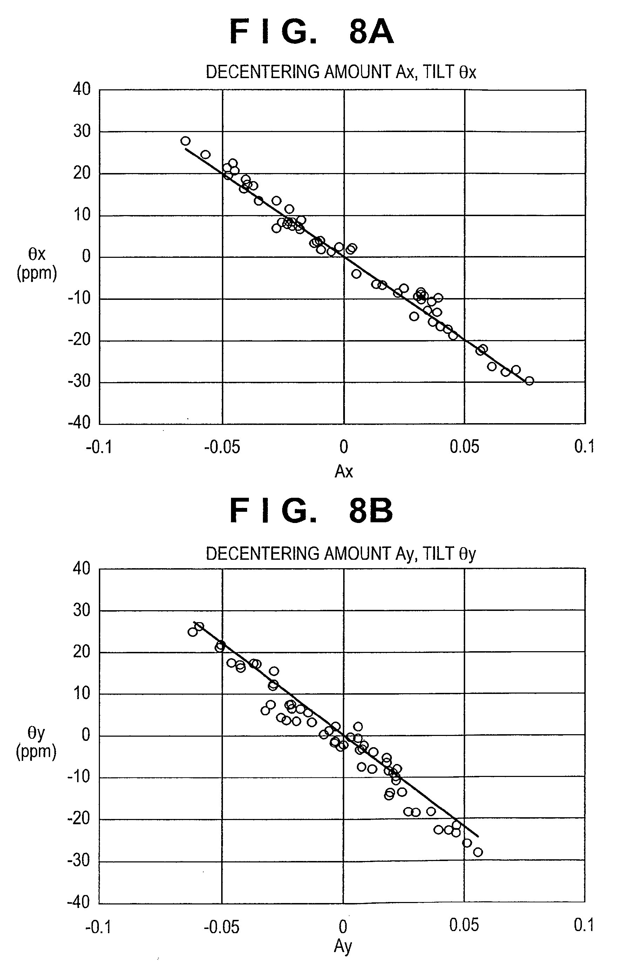

Functions $\theta x = Fx(Ax)$ and $\theta y = Fy(Ay)$ representing the relationships between the relative tilts $\theta x$ and $\theta y$ and the decentering amounts Ax and Ay can generally be complex functions. However, only for Ax and Ay within an actually possible range, the functions can be approximated to linear functions, as shown in Figs. 8A and 8B. That is, the relationships between the relative tilts $\theta x$ and $\theta y$ and the decentering amounts Ax and Ay can be defined as

$$\theta x = Kx \cdot Ax \qquad \ldots (7)$$

$$\theta y = Ky \cdot Ay \qquad \ldots (8)$$

That is, in step S114, the control unit CNT calculates the relative tilts $\theta x$ and $\theta y$ between the mold M and the substrate S based on the decentering amounts Ax and Ay in accordance with equations (7) and (8). In step S116, the control unit CNT controls the driving unit DRV based on the relative tilts $\theta x$ and $\theta y$ between the mold M and the substrate S calculated in step S114 such that each of $\theta x$ and $\theta y$ approaches 0. That is, in this example, the control unit CNT converts the decentering amounts Ax and Ay into correcting amounts for the relative tilts between the mold M and the substrate S, and controls the driving unit DRV so as to correct the relative tilts between the mold M and the substrate S based on the correcting amounts.

In step S118, the control unit CNT determines whether the correction of the relative tilts $\theta x$ and $\theta y$ between the mold M and the S has ended. Upon determining that the correction has not ended yet, the process returns to step S108. Upon determining that the correction has ended, the process advances to step S120. The correction of the relative tilts $\theta x$ and $\theta y$ between the mold M and the S is determined to have ended when, for example, the distance between the outer edge of the interference fringe IF and the outer edge of the shot region becomes less than a predetermined distance. Steps S108 to S118 are repeated, thereby capturing the interference fringe IF a plurality of times and correcting the relative tilts $\theta x$ and $\theta y$ a plurality of times based on a plurality of images obtained by the image capturing.

In step S120, the control unit CNT controls the mold deforming unit MDU so as to enlarge the contact area between the mold M and the imprint material R until the imprint material R dispensed to the shot region of the substrate S completely matches the pattern of the mold M.

In step S122, the control unit CNT controls the driving unit DRV so as to align the shot region of the substrate S with the mold M. That is, in this example, after the relative tilt between the mold M and the substrate S has been corrected a plurality of times, alignment between (the shot region of) the substrate S and the mold M can be done. Alignment between the mold M and the substrate S may be performed before the correction of the relative tilt between the mold M and the substrate S or between the steps of correcting the tilt.

In step S124, the curing unit CU is controlled to cure the imprint material R. Next, in step S126, the driving unit DRV is controlled to separate the cured imprint material R from the mold M.

In the above-described embodiment, immediately after the mold M begins to come into contact with the imprint material R, the contact area between the mold M and the imprint material R is small, and the region where the interference fringe is formed is also small. Hence, errors of the decentering amounts Ax and Ay are large. On the other hand, when the outer edge of the interference fringe approaches the outer edge of the shot region, the interference fringe readily loses its shape. Hence, an improved example of the embodiment will be provided below. In the improved example, if the symmetry of the interference fringe in the image captured by the image capturing unit IC meets a predetermined criterion, the control unit CNT controls the driving unit DRV so as to correct a relative tilt $\theta$ between the mold M and the substrate S based on the image. Here, the control unit CNT can evaluate the symmetry of the interference fringe based on the inner product of the light intensity distribution along a predetermined axis (for example, the X-axis) of the image captured by the image capturing unit IC.

The definition of the inner product will exemplarily be described below. The definition of the inner product may comply with another definition. Let x be a position along a predetermined axis (for example, the X-axis), I(x) be a light intensity distribution along the predetermined axis, and S(x) be the inner product. S(x) can be defined by

$$S(x) = \frac{\int I(-t) \cdot I(t-x) dt}{\int I(t) \cdot I(t) dt} \qquad \ldots (9)$$

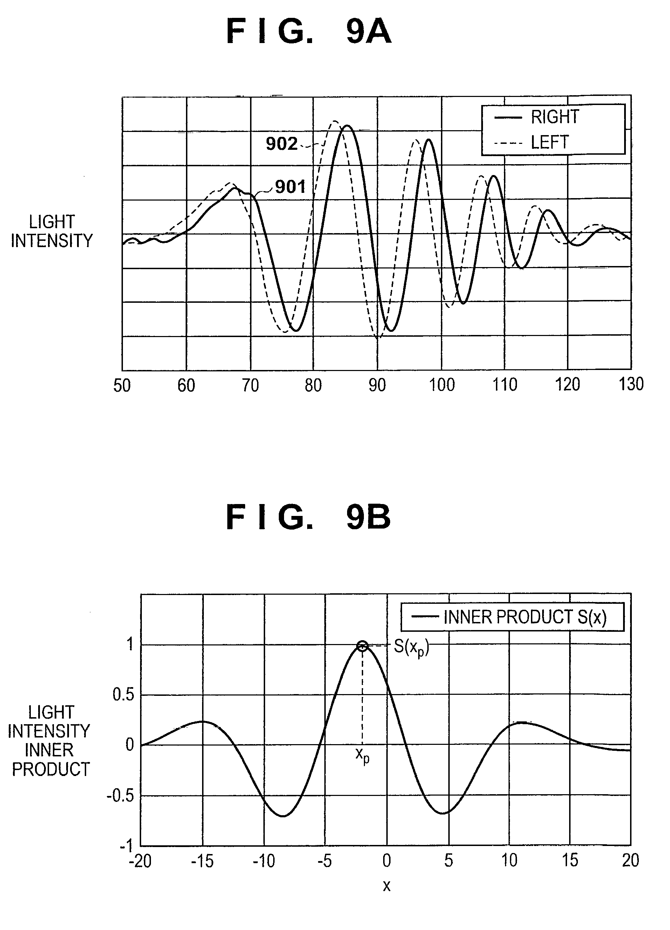

Fig. 9A shows a portion (corresponding to 901) on the right side (a portion where the value x is positive) of Fig. 7A, and a portion (902) on the left side (a portion where the value x is negative) of Fig. 7A which is turned and overlaid on the portion 901. If the degree of matching between the solid line 901 and the dotted line 902 is high, that is, if the symmetry is high, the value of the inner product S(x) is large.

Fig. 9B shows the horizontal deviation of a coordinate $x_p$ where the inner product S(x) exhibits the peak, which corresponds to the above-described deviation amount Δx. A peak value $S_p = S(x_p)$ of the inner product S(x) represents the symmetry in the horizontal direction. If the peak value $S_p$ of the inner product S(x) is high, it means that the symmetry of I(x) (the symmetry in the horizontal direction with respect to $x_p$ as the center) is high. On the other hand, if $S_p$ is low, it means that the symmetry of I(x) (the symmetry in the horizontal direction with respect to $x_p$ as the center) is low. In addition, if the peak value $S_p$ of the inner product S(x) is high, it indicates that the effectiveness of correcting the relative tilt θ between the mold M and the substrate S based on the image captured by the image capturing unit IC is high. On the other hand, if $S_p$ is low, it indicates that the effectiveness of correcting the relative tilt θ between the mold M and the substrate S based on the image captured by the image capturing unit IC is low. Hence, the control unit CNT can be configured to correct the relative tilt θ between the mold M and the substrate S based on the image captured by the image capturing unit IC when the peak value Sp of the inner product S(x) is larger than a predetermined value.

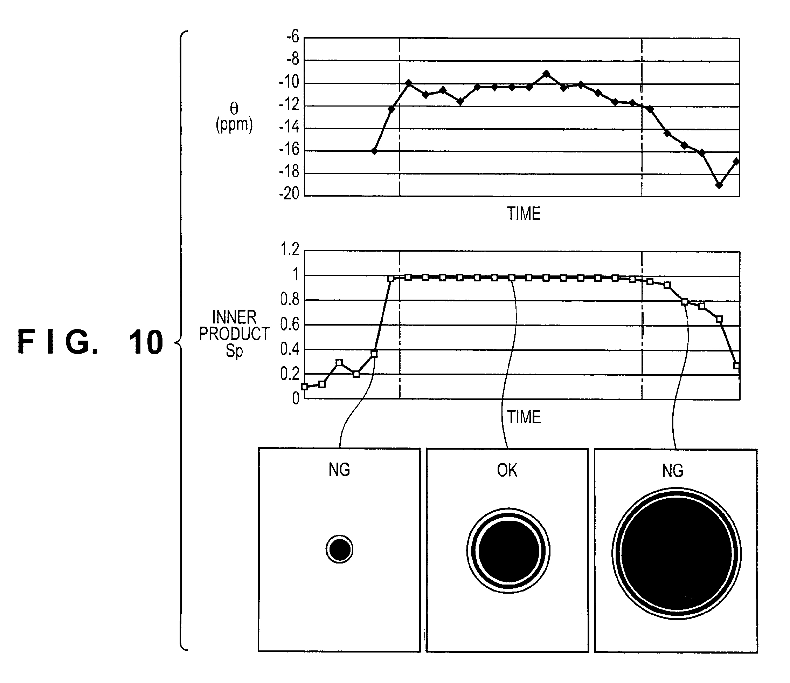

Fig. 10 shows the relative tilt θ and the peak value Sp of the inner product in the contact-area enlarging process. At the early stage of the contact-area enlarging process, the peak value $S_p$ of the inner product rises. After that, the peak value $S_p$ stabilizes near 1 and then lowers. The region where the peak value $S_p$ of the inner product stabilizes indicates that the effectiveness of correcting the relative tilt θ between the mold M and the substrate S based on the image captured by the image capturing unit IC is high.

In another example, the control unit CNT may control the driving unit DRV so as to correct the relative tilt θ based on the image captured by the image capturing unit IC during a period after the size of the contact area between the mold M and the imprint material R exceeds a first threshold until it falls below a second threshold. The first threshold corresponds to the start point of the region where the peak value $S_p$ of the inner product stabilizes, and the second threshold corresponds to the end point of the region where the peak value $S_p$ of the inner product stabilizes.

A method of manufacturing a device (for example, a semiconductor integrated circuit device or a liquid crystal display device) as an article includes a step of forming a pattern on a substrate (a wafer, a glass plate, or a film-shaped substrate) using the above-described imprint apparatus. The manufacturing method can also include a step of processing (for example, etching) the substrate with the pattern being formed. Note that when manufacturing another article such as a pattered medium (recording medium) or an optical device, the manufacturing method can include another process of processing the substrate with the pattern being formed in place of etching. The article manufacturing method according to this embodiment is superior to a conventional method in at least one of the performance, quality, productivity, and production cost of the article.

Other Embodiments

Embodiment(s) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

**Claims**

1. An imprint apparatus for forming a pattern of an imprint material on a substrate using a mold, the imprint apparatus comprising:

    a driving unit configured to adjust a distance and a relative tilt between the mold and the substrate;
    an image capturing unit configured to capture a plurality of times an interference fringe formed by illuminating the substrate via the mold in a process of enlarging a contact area between the mold and the imprint material by reducing the distance between the mold and the substrate by the driving unit; and
    a control unit configured to control the driving unit so as to correct the relative tilt between the mold and the substrate a plurality of times in the process based on images captured by the image capturing unit a plurality of times.

2. The imprint apparatus according to claim 1, wherein the images captured by the image capturing unit include a first image and a second image captured after the first image, and
    the control unit controls the driving unit so as to correct the relative tilt based on a decentering amount of a center of the interference fringe in the second image from a center of the interference fringe in the first image.

3. The imprint apparatus according to claim 2, wherein the control unit converts the decentering amount into a correcting amount for the relative tilt, and controls the driving unit so as to correct the relative tilt based on the correcting amount.

4. The imprint apparatus according to any one of claims 1 to 3, wherein the control unit controls the driving unit so as to perform alignment between the substrate and the mold after correcting the relative tilt the plurality of times.

5. The imprint apparatus according to any one of claims 1 to 4, wherein the control unit controls the driving unit so as to correct the relative tilt based on the image in a case where a symmetry of the interference fringe in the image captured by the image capturing unit meets a predetermined criterion.

6. The imprint apparatus according to claim 5, wherein the control unit evaluates the symmetry based on an inner product of a light intensity distribution along a predetermined axis of the image captured by the image capturing unit.

7. The imprint apparatus according to claim 6, wherein letting x be a position along the predetermined axis, I(x) be the light intensity distribution, and S(x) be the inner product, S(x) is defined by

$$S(x) = \frac{\int I(-t)\cdot I(t-x)dt}{\int I(t)\cdot I(t)dt},$$

and the control unit controls the driving unit so as to correct the relative tilt based on the image in a case where a peak value of S(x) obtained from the image captured by the image capturing unit is larger than a predetermined value.

8. The imprint apparatus according to any one of claims 1 to 4, wherein the control unit controls the driving unit so as to correct the relative tilt based on the image captured by the image capturing unit during a period after a size of the contact area exceeds a first threshold until the size falls below a second threshold.

9. An imprint method of forming a pattern on an imprint material on a substrate using a mold, the method comprising:

    executing an operation of correcting a relative tilt between the mold and the substrate a plurality of times based on an interference fringe formed by illuminating the substrate via the mold in a process of enlarging a contact area between the mold and the imprint material by reducing a distance between the mold and the substrate; and
    curing the imprint material then.

10. An article manufacturing method comprising:

forming a pattern on an imprint material on a substrate using an imprint apparatus of any one of claims 1 to 8, and processing the substrate with the pattern being formed.

**FIG. 1**

# F I G. 2

DISPENSE IMPRINT MATERIAL TO SUBSTRATE — S100

BRING MOLD INTO CONTACT WITH IMPRINT MATERIAL — S102

CAPTURE INTERFERENCE FRINGE — S104

CALCULATE COORDINATES OF CENTER OF INTERFERENCE FRINGE — S106

ENLARGE CONTACT AREA BETWEEN MOLD AND IMPRINT MATERIAL — S108

CAPTURE INTERFERENCE FRINGE — S110

CALCULATE DECENTERING AMOUNT — S112

CALCULATE TILT — S114

CORRECT TILT — S116

S118

TILT CORRECTION PROCESSING ENDED?

NO

YES

ENLARGE CONTACT AREA BETWEEN MOLD AND IMPRINT MATERIAL — S120

ALIGN SUBSTRATE WITH MOLD — S122

CURE IMPRINT MATERIAL — S124

SEPARATE SUBSTRATE FROM MOLD — S126

# F I G. 3A

# F I G. 3B

FIG. 4A          FIG. 4B          FIG. 4C

FIG. 4D          FIG. 4E          FIG. 4F

EP 3 101 476 A2

# F I G. 5

# FIG. 6A

M

S

# FIG. 6B

M

S

# FIG. 6C

y

IF

(Cx,Cy)

x

IMG1

# FIG. 6D

y

IF

(Cx,Cy)

x

IMG2

EP 3 101 476 A2

# FIG. 7A

LIGHT INTENSITY ON X CROSS SECTION

# FIG. 7B

LIGHT INTENSITY ON Y CROSS SECTION

# F I G. 8A

DECENTERING AMOUNT Ax, TILT θx

# F I G. 8B

DECENTERING AMOUNT Ay, TILT θy

# F I G. 9A

# F I G. 9B

F I G. 10

θ (ppm)

TIME

INNER PRODUCT Sp

TIME

NG    OK    NG

EP 3 101 476 A2

**EP 3 101 476 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015056589 A